# EUROPEAN PATENT SPECIFICATION

(11) **EP 2 761 705 B1**
(45) Date of publication and mention of the grant of the patent: **27.11.2019**
(21) Application number: 12790979.4
(22) Date of filing: 27.09.2012
(51) Int. Cl.: H01R 13/658, H01R 13/6599

(54) **WIRE HARNESS**
KABELBAUM
FAISCEAU DE CÂBLES

(30) Priority: 27.09.2011 JP 2011210101
(43) Date of publication of application: 06.08.2014
(73) Proprietor: Yazaki Corporation, Minato-ku Tokyo 108-8333 (JP)
(72) Inventor: ADACHI, Hideomi, Kosai-shi Shizuoka 431-0431 (JP); OZAKI, Yoshiaki, Kosai-shi Shizuoka 431-0431 (JP)
(74) Representative: Grünecker Patent- und Rechtsanwälte PartG mbB
(86) International application number: PCT/JP2012/075736
(87) International publication number: WO 2013/047897

(56) References cited:
- DE-A1- 19 907 675
- US-A1- 2004 099 428
- US-A1- 2005 266 729
- US-A1- 2009 260 232
- US-A1- 2010 046 189
- Anonymous: "Glenair QwikConnect: EMI/RFI Braided Shielding Solutions", Glenair , vol. 15, no. 3 1 July 2011 (2011-07-01), XP002689722, Retrieved from the Internet: URL:http://www.glenair.co.uk/graphics/Qwik Connect/QC0711.pdf [retrieved on 2013-01-04]
- Anonymous: "Flexo Conductive Shielding - Technical Data Sheet", Techflex , 1 January 2009 (2009-01-01), XP002689723, Retrieved from the Internet: URL:http://www.techflex.com/specsheets/fle xo_conductive.pdf [retrieved on 2013-01-04]
- Anonymous: "Carbon Fiber Specialty - Technical Data Sheet", Techflex , 1 January 2009 (2009-01-01), XP002689726, Retrieved from the Internet: URL:http://www.techflex.com/specsheets/car bon.pdf [retrieved on 2013-01-04]

## Description

### Technical Field

The present invention relates to a wire harness including one or a plurality of electrically conducting paths and a shielding member for covering the electrically conducting path(s).

### Background Art

In a shielding structure disclosed in PTL 1, a shield ring is swaged to thereby electrically connect an end of a braided wire laid outside an electric wire to a shield shell placed at a terminal side of the electric wire. In this structure, the braided wire is a so-called shielding member and made by stranding extra fine conductive metallic element wires into a tubular shape. The shield shell is a conductive metal component, and a portion to be connected to an end of the braided wire is formed on a periphery of the shield shell. A portion that allows insertion of the end of the braided wire is formed inside the shield ring. The shield ring is to be swaged by means of a swaging die. When the shield ring is swaged, the braided wire comes into electrical connection with the shield shell upon contact with the same.

"EMI/RFI Braided Shielding Solutions", Glenair QwikConnect, 3/2011, S. 5-21; discloses a conductive composite braid which has a reduced shielding weight and which has a composite thermoplastic base material. In addition, a tapered tubular metal braid is disclosed.

"Flexo Conductive Shiedling - Technical Data Sheet", 2009, discloses a conductive carbon infused nylon (CN) for static protection and shielding. It is also disclosed that the CN is a braided sleeve with a microscopic carbon compound that is virtually indistinguishable from the base material.

"Carbon Fiber Specialty - Technical Data Sheet, 2009; discloses a sleeve made of carbon fiber and which is tightly braided.

### Citation List

### Patent Literature

[PTL 1] Japanese Patent Publication No. JP-A-2009-87902

### Summary of Invention

### Technical Problem

For instance, as many as 300 metallic element wires (metal fibers) are used to form the braided wire of the related art. Accordingly, the braided wire is a comparatively weighty member. Since there are increasing demands for weight reduction of automobile components in recent years, the inventors consider that there is a necessity of amelioration intended for reducing the weight of the braided wire.

Incidentally, there is a recent tendency toward an increase in cost of the braided wire because of a run-up in steel prices. For this reason, the inventors consider that a material impervious to cost must be used.

The invention has been conceived in light of the circumstance and aims at reducing weight and cost of a braided wire and, by extension, addresses a challenge to provide a wire harness whose overall weight and cost can be reduced.

### Solution to Problem

According to one aspect of the present invention, there is provided a wire harness including one or a plurality of electrically conducting paths and a tubular braided wire which is made from a plurality of strands of extra fine element wires and which covers the one or plurality of electrically conducting paths, wherein
the element wires are electrically conductive and made of non-metallic fibers, wherein the wire harness comprises a connector portion formed as a conductive resin shell, which is a conductive resin mold article, terminals, where the tubular braided wire is cut and ends, of a terminal portion of the tubular braided wire are folded to the inside in the axial direction, the terminal portion of the tubular braided wire is integrally molded with an inserted portion of the conductive resin shell, and the terminals are left in a merely cut state and remain simply severed such that the element wires in an internal portion of the terminal portion, which is formed by folding the terminals to the inside, are formed in unbraided state.

According to the invention having such a characteristic, a braided wire is made by stranding conductive element wires of non-metallic fibers into a tubular shape. Such a braided wire is used as a constituent member of a wire harness. In the braided wire, the element wires making up the braided wire are formed from; for instance, non-metallic fibers that are lighter than metallic fibers per unit length. Consequently, the braided wire becomes lighter and impervious to a run-up in steel prices when compared with a braided wire whose element wires are made of metallic fibers.

In the above described wire harness, the non-metallic fibers may be made from carbon fibers or a conductive resin fibers, wherein the conductive resin fibers are formed by mixing carbon fibers or a resin material with a conductive material.

According to the invention having such a characteristic, carbon fibers or conductive resin fibers are used as non-metallic fibers for the element wires.

### Advantageous Effects of Invention

The above defined invention yields an advantage of the ability to reduce the weight and cost of the braided wire. Accordingly, the invention in turn yields an advantage of the ability to reduce the weight and cost of the wire harness.

In the above defined invention, carbon fibers or conductive resin fibers are exemplified as element wires made from non-metallic fibers. An advantage of the ability to reduce the weight and cost of the braided wire can be yielded even when which one of the fibers is used unless other types of fibers are used.

The above defined invention yields an advantage of the ability to provide a wire harness in which the terminal portion of the braided wire is integrated with the metallic shell or the conductive resin shell.

In the following, ways of carrying out the invention are described, wherein the first and third to fifth embodiments are helpful to understand the invention and do not form part of the claimed invention, and the second embodiment is an embodiment of the claimed invention.

### Brief Description of Drawings

Figs. 1A and 1B are drawings showing a wire harness according to a first embodiment, which is helpful to understand the invention;
Fig. 2 is an enlarged perspective view showing a shielding structure of a wire harness terminal;
Figs. 3A and 3B are drawings showing a sheathing member;
Fig. 4 is an enlarged perspective view showing a shielding structure of anther example according to a second embodiment of the invention ;
Figs. 5A to 5C are explanatory views of the shielding structure of Fig. 4 in an unbraided state;
Fig. 6 is an enlarged cross sectional view showing a shielding structure of still another example according to a third embodiment, which is helpful to understand the invention;
Fig. 7 is an enlarged cross sectional view showing a shielding structure of yet another example according to a fourth embodiment, which is helpful to understand the invention;
Fig. 8 is an enlarged cross sectional view showing a cut state of a high voltage cable shown in Fig. 7; and
Fig. 9 is an enlarged cross sectional view showing a shielding structure of yet further example according to a fifth embodiment, which is helpful to understand the invention.

### Description of Embodiments

A braided wire is formed by braiding a conductive element wire made of non-metallic fibers into a tubular shape, and the braided wire is used as a shielding member in a wire harness, thereby covering one or a plurality of electrically conducting paths. Carbon fibers or conductive resin fibers are used as the non-metallic fibers.

### [First Embodiment, which is helpful to understand the invention]

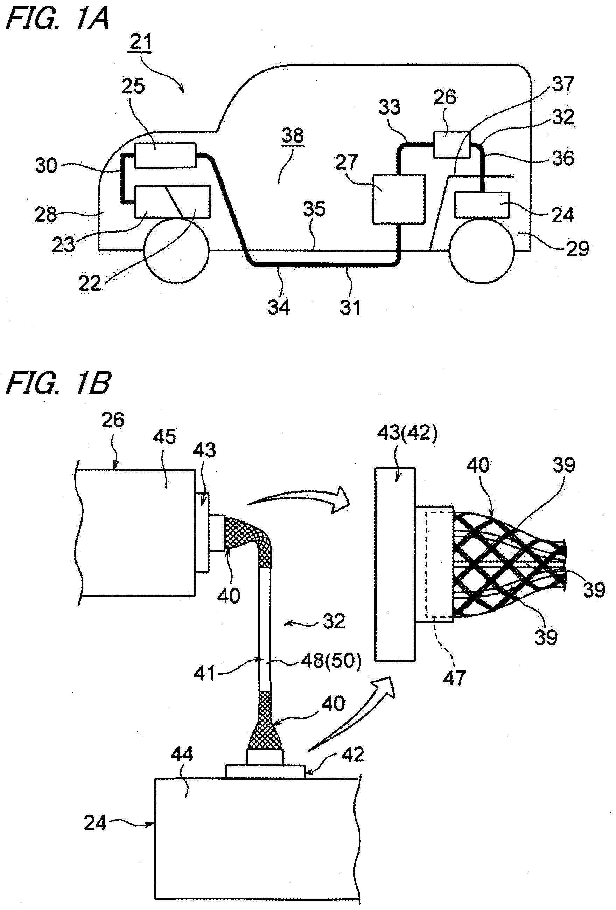

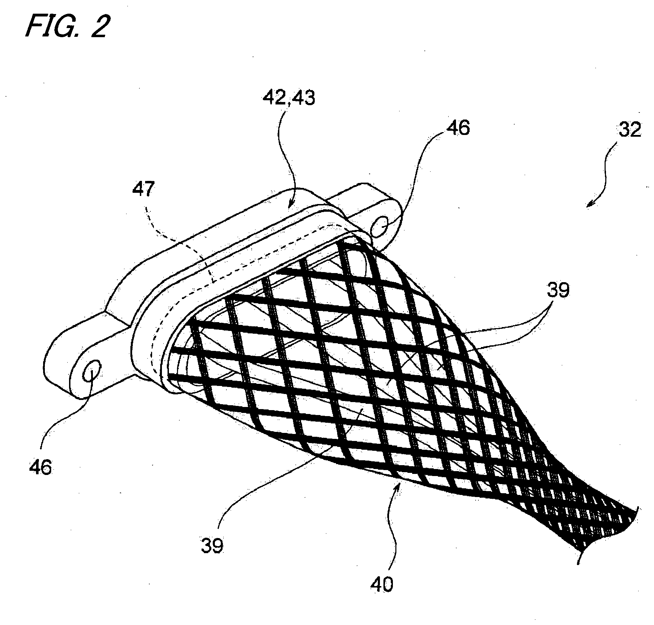

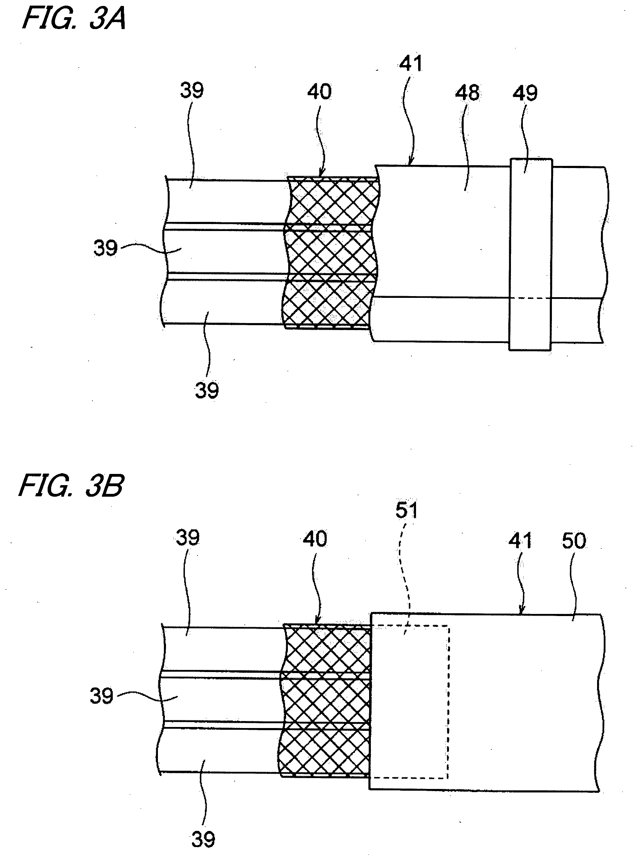

A first embodiment, which is helpful to understand the invention, is hereunder described by reference to the drawings. Figs. 1A and 1B are drawings showing a wire harness of the invention. Fig. 2 is an enlarged perspective view showing a shielding structure of a wire harness terminal, and Figs. 3A and 3B are drawings showing a sheathing member.

In the embodiment, explanations are given with an example in which the wire harness of the present invention is adopted for a hybrid automobile (it can also be an electric vehicle).

In Fig. 1A, reference symbol 21 designates a hybrid automobile. The hybrid automatable 21 is a vehicle that is driven by combined use of an engine 22, a front motor unit 23, a rear motor unit 24. The front motor unit 23 is supplied with electric power from a battery 27 (a battery pack or an assembled battery) by way of a front inverter unit 25, and the rear motor unit 24 is supplied with electric power from the battery 27 by way of a rear inverter unit 26. The engine 22, the front motor unit 23, and the front inverter unit 25 are mounted in an engine room 28 situated at a position where front wheels, and the like, are located in the embodiment. The rear motor unit 24, the rear inverter unit 26, and the battery 27 are mounted in an automobile rear portion 29 where rear wheels, and others, are located (the mount locations are illustrative, and the battery 27 are not particularly limited, so long as it can be used for the hybrid automobile 21, an electric vehicle, and the like.)

The front motor unit 23 and the front inverter unit 25 are connected to each other by means of a high voltage wire harness 30. The front inverter unit 25 and the battery 27 are also connected together by means of a high voltage wire harness 31. Further, the rear motor unit 24 and the rear inverter unit 26 are connected together by means of a high voltage wire harness 32. Moreover, the rear inverter unit 26 and the battery 27 are also connected together by means of a high voltage wire harness 33.

An intermediate portion 34 of the wire harness 31 is routed on a ground side of a bodywork underfloor 35. The wire harness 31 is routed substantially parallel with the bodywork underfloor 35. The bodywork underfloor 35 is a known body and a so-called panel member, and a through hole (whose reference symbol is omitted) is formed at a predetermined position. The through hole is a position where the wire harness 31 is to be inserted.

An intermediate portion 36 of the wire harness 32 is routed so as to pass through a bodywork underfloor 37 of the automobile rear portion 29. A through hole into which the wire harness 32 is to be inserted is formed in the same manner as is the through hole of the wire harness 31. Reference numeral 38 designates a passenger compartment.

The wire harness 30 is connected to the front motor unit 23, and the wire harness 32 is connected to the rear motor unit 24. Therefore, the wire harnesses 30 and 32 are sometimes called motor cables or motor cable devices.

The invention will be hereunder described by taking the wire harness 32 as an example. The invention is not limited to the wire harness 32 but will be applicable to the wire harnesses 30, 31, and 33.

In Fig. 1B, the wire harness 32 is comprised of three high voltage cables 39 (electrically conducting paths); a braided wire 40 collectively shielding the three high voltage cables 39; a sheathing member 41 provided outside a body of the braided wire 40; a motor-side connector portion 42 disposed at one end of the three high voltage cables 39; and an inverter-side connector portion 43 provided at the other end of the same.

In Fig. 1B and Fig. 2, the high voltage cables 39 are high voltage electrically conducting paths including conductors and insulators (cladding) and formed so as to assume lengths required for electrical connection. The conductors are formed from copper, a copper alloy, aluminum, or an aluminum alloy. In relation to the conductor, there can be employed either a conductor structure made by stranding an element wire or a rod-shaped conductor structure assuming a rectangular or circular cross sectional profile (e.g., a conductor structure assuming a straight angle single fiber or a round single fiber, and an electric wire itself assumes a rod shape in this case).

Although the high voltage cables 39 are used in the embodiment, the invention should not be limited to use of the high voltage cables. Specifically, a high voltage electrically conducting path made by providing a known busbar with an insulator, or the like, can also be used.

The braided wire 40 is formed into a tubular member for electromagnetic shielding purpose (a shielding member serving as countermeasures against electromagnetic waves). In the embodiment, the braided wire 40 is formed into a shape that enables coverage of the entire length of the three high voltage cables 39.

A braided wire formed from strands of extra fine conductive element wires made of conductive non-metallic fibers that are lighter than metallic fibers is used as the braided wire 40. Element wires made from carbon fibers or conductive resin fibers formed by mixing a conductive material into a resin material are used as the element wires (as the non-metallic fibers) in the embodiment.

In the braided wire 40, the element wire is formed from; for instance, non-metallic fibers that are lighter than metallic fibers per unit length. Consequently, the braided wire 40 becomes lighter and impervious to a run-up in steel prices when compared with a braided wire whose element wires are made of metallic fibers. A diameter of the element wire is set as appropriate.

The shielding structure of the terminals of the wire harness 32 is one in which one end and the other end (terminal portions) of the braided wire 40 are fastened to the motor-side connector portion 42 and the inverter-side connector portion 43, respectively, to thus be unified. The shielding structure is one in which the braided wire 40 is connected to shielding cases 44 and 45 by way of the motor-side connector portion 42 and the inverter-side connector portion 43.

A little more specific explanation is now given to the shielding structure. The motor-side connector portion 42 and the inverter-side connector portion 43 are conductive resin molded articles formed by mixing a conductive material into a resin material and filling a molding die with the mixture. An outer appearance of the molded article is formed into the same shape as that of a known metallic shell. The motor-side connector portion 42 and the inverter-side connector portion 43 are formed as a conductive resin shell (explanations will be given later to a metallic shell). The resin material and the conductive material are made by mixing carbon fibers into a resin material; for instance, PBT.

The motor-side connector portion 42 and the inverter-side connector portion 43 that correspond to a conductive resin shell exhibit the same shape as that of the metallic shell as mentioned above and, hence, exhibit a function of a securing member. Moreover, the connector portions exhibit the same shape as that of the metallic shell and hence assume a shape that enables the connector portions to be easily connected and fastened to the shielding cases 44 and 45 (reference numeral 46 designates a through hole for bolting purpose).

In relation to the shielding structure, reference numeral 47 in the drawing designates an inserted portion made by insertion of an end (a terminal opening) of the terminal portion of the braided wire 40. Integration of the shielding structure is not achieved exclusively by insert molding but will be accomplished by swaging, adhesion, welding, or the like.

In Figs. 1B and 3A, the sheathing member 41 is a member intended for coverage of the three high voltage cables 39 and the braided wire 40, to thus protect them. For instance, a twisted tube 48, or the like, is used. The twisted tube 48 is formed as a member to be coiled around the outside of the braided wire 40 and retained by a tape coil 49.

The sheathing member 41 can also be a tubular body 50 as illustrated in Fig. 3B. The tubular body 50 of the embodiment is a conductive resin molded article. Specifically, the tubular body 50 is molded by mixing a conductive material into a resin material and filling a molding die with the resultant mixture (the resin material and the conductive material are formed by mixing carbon fibers into a resin material; for instance, PBT). The tubular body 50 is formed so as to assume; for instance, the shape of a pipe having a circular cross sectional profile. Insertion and integration of the end of the braided wire 40 is adduced as example molding of the tubular body 50. Reference numeral 51 designates an inserted portion.

In addition to the conductive resin molded articles, a common metallic pipe can also be adduced as an example of the tubular body 50. In this case, as a matter of course, it is possible to endow the metallic pipe with the capability of a shielding member, so long as the terminal portion of the braided wire 40 is fixed with a band, a swaging ring, or the like.

As has been described by reference to Figs. 1A through 3B, the wire harness 32 of the invention uses the braided wire 40 made by stranding element wires made from conductive non-metallic element fibers into a tubular shape. The braided wire becomes lighter and impervious to a run-up in steel prices when compared with a braided wire, such as a related art braided wire whose element wires are made of metallic fibers.

The invention yields an advantage of the ability to reduce the weight and cost of the braided wire 40. Accordingly, the invention yields an advantage of the ability to reduce the weight and cost of the wire harness 32.

In addition, since the wire harness 32 of the invention has been reduced in weight, there is yielded an advantage of the ability to contribute to improvement of fuel efficiency of the hybrid automobile 21 in which the wire harness 32 is routed.

It is natural that the invention is not limited to the hybrid automobile 21 or a pure electric vehicle but can also be applied to; for instance, a sports car that entails weight reduction.

### [Second Embodiment]

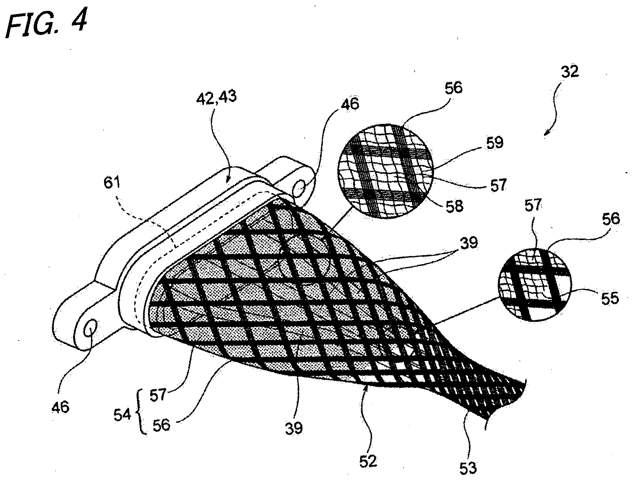

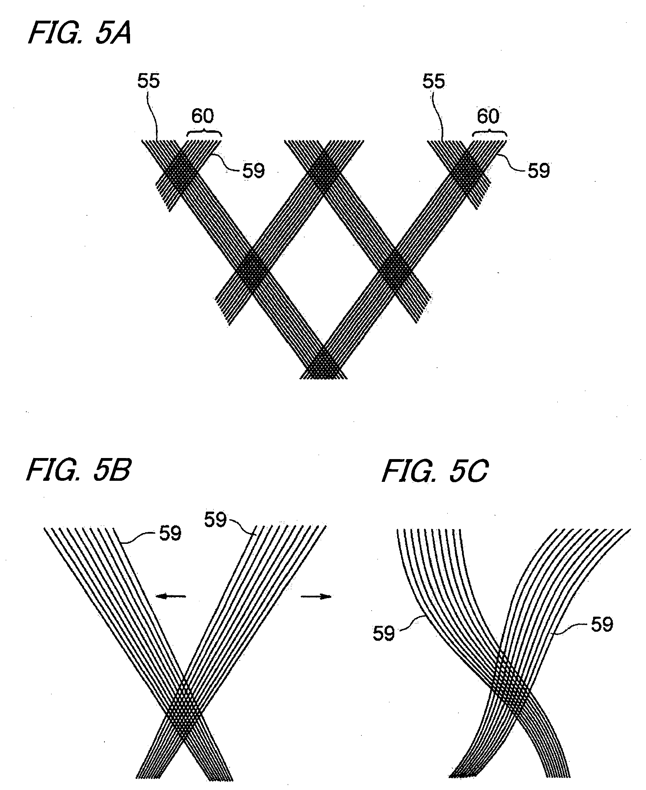

A second embodiment is hereunder described by reference to the drawings. Fig. 4 is an enlarged perspective view showing a shielding structure of another embodiment. Figs. 5A to 5C are explanatory views of the shielding structure of Fig. 4 in an unbraided state. The constituent members that are the same as those described in connection with the first embodiment are assigned the same reference numerals, and their detailed explanations are omitted. Reference is made to Fig. 1 in connection with the second embodiment.

In Fig. 1B and 4, the wire harness 32 routed in the same manner as described in connection with the first embodiment is made up of the three high voltage cables 39 (electrically conducting paths); a braided wire 52 that collectively shields the three high voltage cables 39; a sheathing member 41 disposed outside the main body of the braided wire 52; the motor-side connector portion 42 to be provided at one side of the three high voltage cables 39; and the inverter-side connector portion 43 to be provided at the other side of the same. A shielding structure embodied by the insert molding in the same manner as in the first embodiment is adopted for the wire harness 32 having such a structure.

The braided wire 52 is formed into a tubular member for electromagnetic shielding purpose (a shielding member serving as countermeasures against electromagnetic waves). In the embodiment, the braided wire 52 is formed into a shape that enables coverage of the entire length of the three high voltage cables 39.

A braided wire formed from strands of extra fine element wires made from conductive non-metallic fibers that are lighter than metallic fibers is used as the braided wire 52 in the same way as in the first embodiment. In the braided wire 52, the element wires are made from non-metallic fibers that are lighter per unit length than the metallic fibers. Accordingly, the braided wire becomes lighter and impervious to a run-up in steel prices when compared with a braided wire whose element wires are made of metallic fibers. The braided wire 52 differs from its counterpart described in connection with the first embodiment in that a terminal portion 54, which will be described later, of the braided wire 52 assume a double structure. The double structure is now described hereunder.

In Fig. 4, reference numeral 53 designates a main body of the braided wire 52. Reference numeral 54 designates a terminal portion continuous with the main body 53. The braided wire 52 is formed such that an inner diameter of the terminal portion 54 becomes greater than an inner diameter of the main body 53. The braided wire 52 is also formed such that terminals 55 of the terminal portion 54 are folded inside along an axial direction of the braided wire 52, to thus form a double structure. Specifically, the terminal portion 54 is formed into a double structure made up of an external terminal portion 56 and an internal terminal portion 57.

The braided wire 52 is doubly formed while the terminals 55 of the terminal portion 54 remain cut and unfinished (in other words, the braided wire 52 is left simply severed). The braided wire 52 is formed, while remaining in a merely cut state, such that the internal terminal portion 57 includes the terminals 55 and that the element wires remain unbraided. In Fig. 4, the internal terminal portion 57 is diagrammatically illustrated with hatch lines. The internal terminal portion 57 is illustrated in circles of Fig. 4 to make an unbraided state of the element wires clear.

A little more specific explanation is now given to the unbraided state. As shown in the circles of Fig. 4, the unbraided state designates a state in which element wires 59 cross each other on the inside of a mesh 58 of the external terminal portion 56. In relation to formation of the unbraided state, the terminals 55 that are to become leading ends are left in a merely cut state (remain simply severed) at the sight of a pick 60 made up of a plurality of element wires 59 as illustrated in Fig. 5A. Subsequently, a bundle of the element wires 59 in each of the picks 60 is unbraided from a state shown in Fig: 5B to a state shown in Fig. 5C. Although unillustrated particularly, the unbraided state includes a state in which the element wires 59 are scraggly formed.

In the unbraided state, such as that mentioned above, the terminals 55 of the terminal portion 54 are set so as to be placed at, or in the vicinity of, a position where they become continuous with a main body 53.

The shielding structure of the terminal of the wire harness 32 is one in which the terminal portion 54 of the braided wire 52 is fastened to the motor-side connector portion 42 and the inverter-side connector portion 43, thereby integrating the connector portions. Further, the shielding structure is one in which the braided wire 52 is connected to the shielding cases 44 and 45 by way of the motor-side connector portion 42 and the inverter-side connector portion 43.

The shielding structure is analogous its counterpart described in connection with the first embodiment, which is helpful to understand the invention. The shielding structure includes the portion folded inside along the axial direction, which is formed in the terminal portion 54 of the braided wire 52, thereby integrally molding the braided wire. Reference numeral 61 in the drawing designates an inserted portion where the terminal portion 54 of the braided wire 52 is inserted.

As has been described by reference to Fig. 4 and Figs. 5A to 5C, the wire harness 32 of the invention employs the braided wire 52 formed by stranding element wires of conductive non-metallic fibers into a tubular shape. Therefore, the braided wire becomes lighter and impervious to a run-up in steel prices when compared with a braided wire, such as a related art braided wire whose element wires are made of metallic fibers.

The invention yields an advantage of the ability to reduce the weight and cost of the braided wire 52. Accordingly, the invention yields an advantage of the ability to reduce the weight and cost of the wire harness 32.

The braided wire 52 is characterized as follows: The braided wire 52 has the tubular main body 53 and the tubular terminal portion 54 that is continuous with the main body 53. An inner diameter of the terminal portion 54 is made larger than an inner diameter of the main body 53. The terminals 55 of the terminal portion 54 are folded to the inside in the axial direction, thereby endowing the terminal portion 54 with a double structure including the external terminal portion 56 and the internal terminal portion 57. Moreover, in the braided wire 52, the terminals 55 of the terminal portion 54 are left in a merely cut state, or an unfinished state. Further, the internal terminal portion 57 is formed, while including the terminals 55 left cut, in such a way that the element wires 59 are unbraided.

### [Third Embodiment, which is helpful to understand the invention]

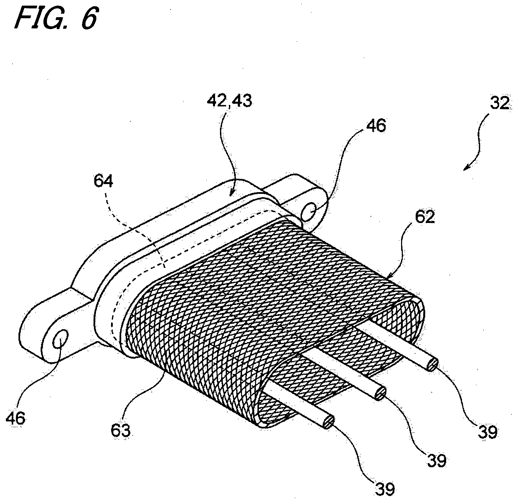

A third embodiment, which is helpful to understand the invention, is hereunder described by reference to the drawings. Fig. 6 is an enlarged perspective view of a shielding structure that is to be still another embodiment. The constituent members that are the same as those described in connection with the first embodiment, which is helpful to understand the invention, and second embodiment are assigned the same reference numerals, and their detailed explanations are omitted.

In Fig. 6, the shielding structure of the third embodiment, which is helpful to understand the invention, differs from its counterparts described in connection with the first embodiment, which is helpful to understand the invention, and second embodiment in use of a braided wire 62. A braided wire formed from strands of extra fine conductive element wires made of conductive non-metallic fibers that are lighter than metallic fibers is used as the braided wire 62 in the same way as in the first embodiment, which is helpful to understand the invention, and second embodiment. In the braided wire 62, the element wires are formed from; for instance, non-metallic fibers that are lighter than metallic fibers per unit length. Consequently, the braided wire becomes lighter and impervious to a run-up in steel prices when compared with a braided wire, such as a related art braided wire whose element wires are made of metallic fibers. The braided wire 62 is formed in such a way that meshes become smaller than those of the braided wire described in connection with the first embodiment, which is helpful to understand the invention, to enable enhancement of a shielding effect.

The braided wire 62 is formed in such a tubular shape that an inner diameter of a terminal portion 63 becomes equal to an inner diameter of an unillustrated main body which is continuous with the terminal portion 63. Terminal openings of the terminal portion 63 are formed so as to be integrated with the motor-side connector portion 42 and the inverter-side connector portion 43.

Reference numeral 64 in the drawing denotes an inserted portion made by insertion of the terminal portion 63 of the braided wire 62 (integration of the shielding structure is not achieved exclusively by insert molding but can also be accomplished by swaging, adhesion, welding, or the like.).

As a matter of course, even the shielding structure as mentioned above can also yield the same advantages yielded in the first embodiment, which is helpful to understand the invention, and second embodiment. Specifically, the wire harness 32 of the invention employs the braided wire 62 formed by stranding conductive element wires of non-metallic fibers into a tubular shape. Accordingly, the braided wire becomes lighter and impervious to a run-up in steel prices when compared with a braided wire, such as that a related art braided wire whose element wires are made of metallic fibers.

The present invention yields an advantage of the ability to reduce the weight and cost of the braided wire 62. Accordingly, the present invention yields an advantage of the ability to reduce the weight and cost of the wire harness 32.

### [Fourth Embodiment, which is helpful to understand the invention]

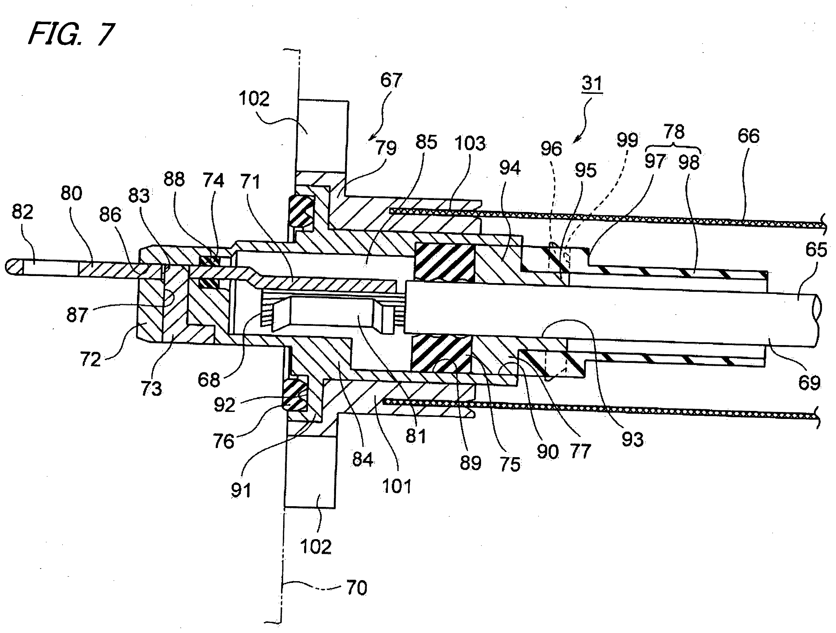

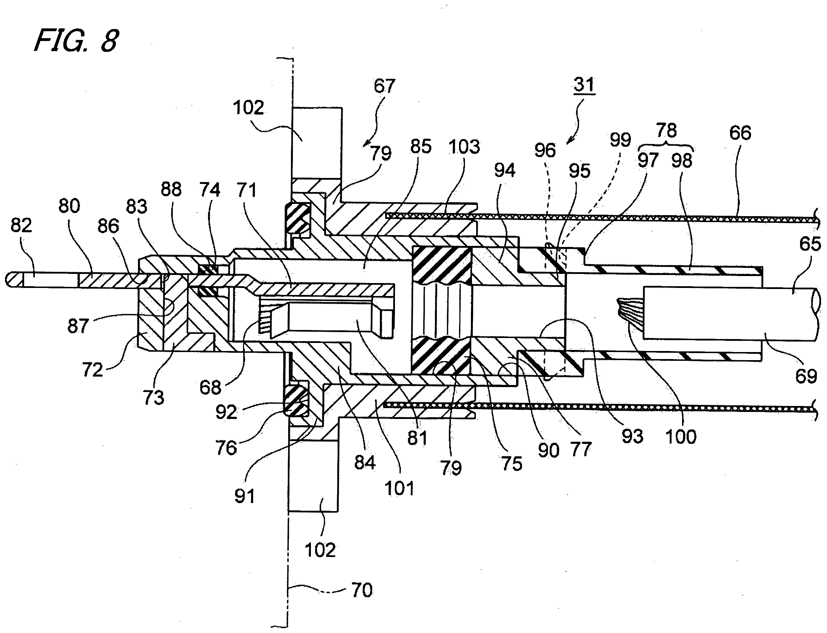

A fourth embodiment, which is helpful to understand the invention, is hereunder described by reference to the drawings. Fig. 7 is an enlarged cross sectional view of a shielding structure that is to serve as yet another embodiment. Fig. 8 is an enlarged cross sectional view showing a cut state of the high voltage cables shown in Fig. 7. A reference is made also to Fig. 1 even in the fourth embodiment, which is helpful to understand the invention.

The fourth embodiment, which is helpful to understand the invention, is described by means of taking as an example the wire harness 31 in place of the wire harness 32.

In Fig. 7, the wire harness 31 includes two high voltage cables 65 (electrically conducting paths, and only one of them is illustrated), a braided wire 66 that collectively shields the two high voltage cables 65, an unillustrated sheathing member disposed outside the braided wire 66, an inverter-side connector portion 67 placed at one end of the high voltage cable 65, and an unillustrated battery-side connector portion disposed at the other end of the same. The unillustrated battery-side connector portion is basically configured in the same manner as is the inverter-side connector portion 67.

The high voltage cables 65 include conductors 68 and insulators 69 that sheath the conductors 68. The high voltage cables 65 are processed by peeling off the insulators 69 from the terminals to a predetermined length, to thus bare the conductors 68. A conductor structured by stranding element wires (element wires made from copper, a copper alloy, aluminum, or an aluminum alloy) is used as the conductors 68. Although not specifically limited, the conductors 68 are formed so as to assume a substantially circular cross sectional profile (a circle). In relation to the conductors 68, there can be employed either a conductor made in a rod-shaped conductor structure assuming a rectangular or a circular cross sectional profile (e.g., a conductor structure assuming a straight angle single fiber or a round single fiber). Moreover, a conductor with a structure made up of; for instance, a braided wire busbar can also be used.

The insulators 69 are formed by extruding an insulating resin material outside the conductors 68 and sheathing the thus-extruded resin material. A known insulator is used in the embodiment.

Since the high voltage cables 65 are for high voltage use, they are formed in thick cables.

The braided wire 66 is a member for exhibiting an electromagnetic shielding function and is formed into a tubular shape. Any one of the braided wire 40 of the first embodiment (see Fig. 2), which is helpful to understand the invention, the braided wire 52 of the second embodiment (see Fig. 4), and the braided wire 62 (see Fig. 6) of the third embodiment, which is helpful to understand the invention, is used for the braided wire 66 of the embodiment. One end (the terminal portion) of the braided wire 66 is formed integrally with a conductive resin molded article 79 to be described later in the inverter-side connector portion 67 by means of integral molding. The other end (terminal portion) of the same is likewise formed integrally with the unillustrated battery-side connector portion.

The inverter-side connector portion 67 is a so-called connector that is configured so as to undergo electrical connection within a shielding case 70 of the front inverter unit 25 when inserted into the shielding case 70. The inverter-side connector portion 67 includes terminal fitting 71, a housing 72, a terminal engagement member 73, waterproof shielding members 74 to 76, a rear holder 77, an insulating cover 78, the conductive resin molded article 79, and a fixing bolt (omitted from the drawing).

The terminal fitting 71 is formed by pressing a conductive metal plate. A male-type terminal fitting is herein used as the terminal fitting 71. The terminal fitting 71 has an electrical contact 80 and an electric cable connector portion 81 that is continuous with the electrical contact 80.

The electrical contact 80 is formed into the shape of a tab. A first through hole 82 and a second through hole 83 are formed in the electrical contact 80. The first through hole 82 is formed as an area used for electrical connection within the front inverter unit 25. In the meantime, the second through hole 83 is formed as an area to be engaged with the terminal engagement member 73.

The electric cable connector portion 81 is formed so as to enable fastening and connection of the conductors 68 of the high voltage cables 65. In the embodiment, the electric cable connector portion 81 is formed into a barrel shape so as to enable crimping and connection of the conductors 68 by means of swaging (in relation to a connection, welding is also employable).

The housing 72 is an insulating resin molded article (an insulating member) and is formed into an illustrative geometry with a housing main body 84 (the geometry is illustrative).

A terminal accommodation chamber 85 is formed within the housing main body 84. The terminal accommodation chamber 85 is formed so as to be able to accommodate primarily the electric cable connector portion 81 of the terminal fitting 71 fixedly connected to the conductors 68 of the high voltage cables 65. An electrical contact lead-out hole 86 is formed so as to pass through the terminal accommodation chamber 85 toward a leading end of the housing 72. When the terminal fitting 71 is accommodated in the terminal accommodation chamber 85, the electrical contact 80 juts out of the leading end of the housing 72 by way of the electrical contact lead-out hole 86.

A terminal engagement member accommodation hole 87 that is in mutual communication with the electrical contact lead-out hole 86 is formed up from below in the housing main body 84. The terminal engagement member 73 that is to fit into the terminal engagement member accommodation hole 87 is engaged with the second through hole 83, whereby the terminal fitting 71 is retained.

A sealing member accommodation hole 88 is formed in an area where the terminal accommodation chamber 85 is continuous with the electrical contact lead-out hole 86. The sealing member 74 accommodated in the sealing member accommodation hole 88 contacts the electrical contact portion 80 in a watertight manner.

A sealing member accommodation hole 89 is continuously formed to rearward of the terminal accommodation chamber 85. A rear holder accommodation hole 90 is additionally formed to the rear of the sealing member accommodation hole 89. The sealing member 75 accommodated in the sealing member accommodation hole 89 contacts the insulators 69 of the respective high voltage cables 65 in a watertight manner. The rear holder accommodation hole 90 is formed in a shape that enables fitting of the rear holder 77.

A flange 91 is formed outside the housing main body 84. A sealing member accommodation groove 92 is formed in the flange 91. The sealing member 76 accommodated in the sealing member accommodation groove 92 contact the shielding case 70 of the front inverter unit 25 in a watertight manner.

The rear holder 77 is an insulating resin molded article and is formed, although not specifically illustrated, into a shape by means of which the rear holder can be separated into two. The rear holder 77 includes electric cable insert holes 93 that each penetrates through the rear holder 77 in agreement with a diameter of the high voltage cable 65; a large-diameter fitting portion 94 that fits into the rear holder accommodation hole 90; a small-diameter electric cable pullout portion 95 that is continuous with the fitting portion 94 and enables pullout of the high voltage cables 65; and an engagement projection 96 that is formed at an end of the electric cable pullout portion 95 so as to project; for instance, in the vertical direction. The engagement projection 96 is formed so as to be able to catch the insulating cover 78 and regulate fall of the insulating cover 78.

The insulating cover 78 is provided as a member that is separate from the rear holder 77. Further, the insulating cover 78 is a flexible member and provided in the embodiment as a rubber member (an elastomer member). The insulating cover 78 is formed in a tubular form and has a large-diameter engagement portion 97 and a cover 98 extending from the engagement portion 97 to the rear. An engagement dent 99 that catches an engagement projection 96 of the rear holder 77, to thus be engaged with the engagement projection 96 is formed in the engagement portion 97. The insulating cover 78 is formed in such a shape that the cover is engaged with the rear holder 77 even when turned upside down with a 180-degree rotation.

The insulating cover 78 can be said to be a member that is effective when external forces, or the like, act on the wire harness 31. The reason for this will be described below.

If external forces, or the like, act on the wire harness 31, a connection between the conductors 68 of the high voltage cables 65 and the electric cable connector portion 81 of the terminal fitting 71 is subjected to the external forces. The conductors 68 are disconnected at the connection as illustrated in Fig. 8. Specifically, the conductors 68 are disconnected such that some of the conductors 68 remain in a swaged portion of the electric cable connector portion 81 and that a conductor cut end 100 becomes bare in the high voltage cable 65. The conductor cut end 100 becomes bare in the high voltage cables 65 at this time, but an exterior of the conductor cut end 100 is sheathed in the insulating cover 78. Therefore, an electrical contact with the braided wire 66 is regulated. When an amount of movement of the wire harness is small, the exterior of the conductor cut end 100 is sheathed with the housing main body 84 or the fitting portion 94 and the electric cable pullout portion 95 in the rear holder 77, whereby the electrical connection with the braided wire 66 becomes regulated.

Accordingly, exposure of the conductor cut end 100 is prevented by presence of the insulating cover 78, or the like, so that safety can be assured. Therefore, the insulating cover 78 can be said to be a member that is effective when external forces, or the like, are exerted on the wire harness 31.

The conductive resin molded article 79 is an alternative of a so-called metallic shell (a shielded shell). The article is formed by mixing a conductive material into a resin material and filling a molding die with the mixture. The conductive resin molded article 79 has a substantially tubular molded article main body 101 (a shell main body) and a plurality of molded article fixing portions 102 (shell fixing portions). The molded article main body 101 is formed in such a shape that the housing main body 84 can be accommodated in the molded article main body 101. The molded article fixing portions 102 are formed in such a shape as to be fixed to the shielding case 70 of the front inverter unit 24 by use of unillustrated fixing bolts.

In the molded article main body 101, terminal portions (i.e., terminal openings) of the braided wire 66 are integrally formed. Reference numeral 103 in the drawing designates an inserted portion of the terminal portion of the braided wire 66. Integration of the shielding structure is not achieved exclusively by insert molding but can also be accomplished by swaging, adhesion, welding, or the like.

As a matter of course, the shielding structure, such as that mentioned above, can also yield an advantage analogous to those yielded in the first through third embodiments, which is helpful to understand the invention. Specifically, the wire harness 31 of the invention employs the braided wire 66 formed by stranding conductive element wires of non-metallic fibers into a tubular shape. Accordingly, the braided wire becomes lighter and impervious to a run-up in steel prices when compared with a braided wire, such as a related art braided wire whose element wires are made of metallic fibers.

The present invention yields an advantage of the ability to reduce the weight and cost of the braided wire 66. Accordingly, the present invention yields an advantage of the ability to reduce the weight and cost of the wire harness 31.

### [Fifth Embodiment, which is helpful to understand the invention]

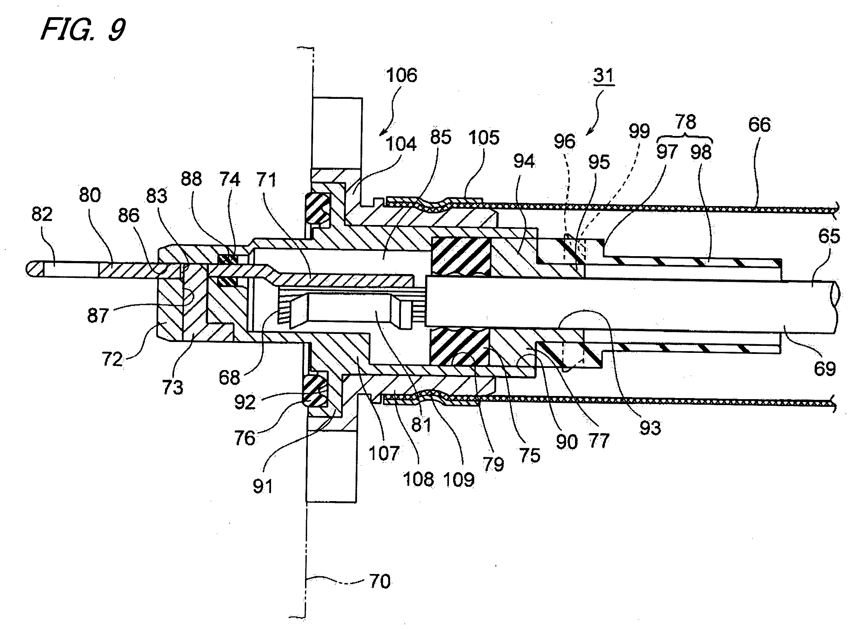

A fifth embodiment, which is helpful to understand the invention, is hereunder described by reference to the drawings. Fig. 9 is an enlarged cross sectional view of a shielding structure that is to serve as yet further embodiment. The constituent members that are the same as those described in connection with the fourth embodiment, which is helpful to understand the invention, are assigned the same reference numerals, and their detailed explanations are omitted.

In Fig. 9, a shielding structure of the fifth embodiment, which is helpful to understand the invention, differs from the structure of the fourth embodiment, which is helpful to understand the invention, in that the structure integrates the braided wire 66. Specifically, the braided wire 66 is structurally different in that the wire is not fixed by insert molding but by swaging. The fixing structure using swaging will be understood from Fig. 9 and descriptions provided below. The fixing structure employs a metallic shell 104 and a swaging ring 105.

The metallic shell 104 making up an inverter-side connector portion 106 is provided as a member comparable to the conductive resin molded article 79 of the fourth embodiment (see Figs. 7 and 8), which is helpful to understand the invention. Such a metallic shell 104 has a tubular shell main body 107 and a plurality of shell fixing portions 108. The shell fixing portions 108 are formed in such a shape as to be fixed to the shielding case 70 of the front inverter unit 25 by use of unillustrated fixing bolts.

A swage receiving portion 109 is formed in the shell main body 107. A terminal portion of the braided wire 66 is nipped between the swage receiving portion 109 and the swaging ring 105. When the terminal portion is fixedly nipped by swaging, the braided wire 66 is electrically connected to the shielding case 70.

Even when the structure for integrating the braided wire 66 differs from its counterpart described in connection with the fourth embodiment, which is helpful to understand the invention, the fifth embodiment, which is helpful to understand the invention, is understood to yield the same advantage as that yielded in the fourth embodiment, which is helpful to understand the invention. Specifically, the invention yields an advantage of the ability to reduce the weight and cost of the wire harness 31.

It is apparent that various modifications can be made in the invention within a scope not deviating from the scope of the invention as defined in the claims. The present application is based on Japanese patent application No. 2011-210101 filed on September 27, 2011.

### Industrial Applicability

The present invention is useful for providing a wire harness whose overall weight and cost can be reduced by reducing weight and cost of a braided wire.

### Reference Signs List

21 ... HYBRID AUTOMOBILE, 22 ... ENGINE, 23 ... FRONT MOTOR UNIT, 24 ... REAR MOTOR UNIT, 25 ... FRONT INVERTER UNIT, 26 ... REAR INVERTER UNIT, 27 ... BATTERY, 28 ... ENGINE ROOM, 29 ... AUTOMOBILE REAR PORTION, 30 TO 33 ... WIRE HARNESS, 34, 36 ... INTERMEDIATE PORTION, 35, 37 ... BODYWORK UNDERFLOOR, 38 ... PASSENGER COMPARTMENT, 39 ... HIGH VOLTAGE CABLE (ELECTRICALLY CONDUCTING PATH), 40 ... BRAIDED WIRE, 41 ... SHEATHING MEMBER, 42 ... MOTOR-SIDE CONNECTOR PORTION (CONDUCTIVE RESIN SHELL), 43 ... INVERTER-SIDE CONNECTOR PORTION (CONDUCTIVE RESIN SHELL), 44, 45 ... SHIELDING CASE, 46 ... THROUGH HOLE, 47 ... INSERTED PORTION, 48 ... TWISTED TUBE, 49 ... TAPE COIL, 50 ... TUBULAR BODY, 51 ... INSERTED PORTION, 52 ... BRAIDED WIRE, 53 ... MAIN BODY, 54 ... TERMINAL PORTION, 55 ... TERMINAL, 56 ... EXTERNAL TERMINAL PORTION, 57 ... INTERNAL TERMINAL PORTION, 58 ... BRAIDED WIRE, 59 ... ELEMENT WIRE, 60 ... PICK, 61 ... INSERTED PORTION, 62 ... BRAIDED WIRE, 63 ... INSERTED PORTION, 64 ... TERMINAL PORTION, 65 ... HIGH VOLTAGE CABLE (ELECTRICALLY CONDUCTING PATH), 66 ... BRAIDED WIRE, 67 ... INVERTER-SIDE CONNECTOR PORTION, 71 ... TERMINAL FITTING, 72 ... TERMINAL FITTING, 73 ... TERMINAL ENGAGEMENT MEMBER, 74 TO 76 ... SEALING MEMBER, 77 ... REAR HOLDER, 78 ... INSULATION COVER, 79 ... CONDUCTIVE RESIN MOLDED ARTICLE (CONDUCTIVE RESIN SHELL), 96 ... ENGAGEMENT PROJECTION, 97 ... ENGAGEMENT PORTION, 98 ... COVER, 99 ... ENGAGEMENT DENT, 100 ... CONDUCTOR CUT END, 101 ... MOLDED ARTICLE BODY, 102 ... MOLDED ARTICLE FIXING PORTION, 103 ... INSERTED PORTION, 104 ... METAL SHELL, 105 ... SWAGING RING, 106 ... INVERTER-SIDE CONNECTOR PORTION, 107 ... SHELL BODY, 108 ... SHELL FIXING PORTION, 109 ... SWAGE RECEIVING PORTION

## Claims

1. A wire harness (30 to 33) including one or a plurality of electrically conducting paths (39) and a tubular braided wire (52) which is made from a plurality of strands of extra fine element wires and which covers the one or plurality of electrically conducting paths (39), wherein
the element wires are electrically conductive and made of non-metallic fibers, **characterized in that** the
wire harness (30 to 33) comprises a connector portion formed as a conductive resin shell (42, 43), which is a conductive resin mold article,
terminals (55), where the tubular braided wire is cut and ends, of a terminal portion (54) of the tubular braided wire (52) are folded to the inside in the axial direction,
the terminal portion (54) of the tubular braided wire (52) is integrally molded with an inserted portion (61) of the conductive resin shell (42, 43), and
the terminals (55) are left in a merely cut state and remain simply severed such that the element wires (59) in an internal portion (57) of the terminal portion (54), which is formed by folding the terminals (55) to the inside, are formed in unbraided state.

2. The wire harness (30 to 33) according to claim 1, wherein the non-metallic fibers are made from carbon fibers or conductive resin fibers, wherein the conductive resin fibers are formed by mixing a conductive material into a resin material.

## Patentansprüche

1. Kabelbaum (30 bis 33) mit einem oder mehreren elektrisch leitenden Kanälen (39) und einer rohrförmigen geflochtenen Verdrahtung (52), die aus mehreren Litzen aus extrafeinen Elementdrähten aufgebaut ist und den einen oder die mehreren elektrisch leitenden Kanäle (39) bedeckt, wobei
die Elementdrähte elektrisch leiten und aus nichtmetallischen Fasern hergestellt sind, **dadurch gekennzeichnet, dass**
der Kabelbaum (30 bis 33) einen Verbindungsbereich aufweist, der als eine leitende Harzschale (42, 43) ausgebildet ist, die ein leitendes Harzgießprodukt ist,
Anschlüsse (55) der rohrförmigen geflochtenen Verdrahtung (52), an denen die rohrförmige geflochtene Verdrahtung abgeschnitten ist und endet, in der axialen Richtung nach innen gefaltet sind,
der Anschlussbereich (54) der rohrförmigen geflochtenen Verdrahtung (52) integral mit einem eingeführten Bereich (61) der leitenden Harzschale (42, 43) geformt ist, und
die Anschlüsse (55) in einem nur geschnittenen Zustand belassen sind und einfach nur abgetrennt verbleiben derart, dass die Elementdrähte (59) in einem inneren Bereich (57) des Anschlussbereichs (54), der durch Umklappen der Anschlüsse (55) nach innen gebildet ist, in einem ungeflochtenen Zustand ausgebildet sind.

2. Kabelbaum (30 bis 33) nach Anspruch 1, wobei die nichtmetallischen Fasern aus Karbonfasern oder leitenden Harzfasern hergestellt sind, und wobei die leitenden Harzfasern durch Zumischen eines leitenden Materials zu einem Harzmaterial hergestellt sind.

## Revendications

1. Faisceau de câbles (30 à 33) incluant une ou une pluralité de lignes électriquement conductrices (39) et un câble tressé tubulaire (52) qui est constitué d'une pluralité de brins de fils élémentaires extra fins et qui recouvre ladite ligne où ladite pluralité de lignes électriquement conductrices (39), dans lequel
les fils élémentaires sont électriquement conducteurs et sont constitués de fibres non métalliques,
**caractérisé en ce que**
le faisceau de câbles (30 à 33) comprend un organe formant connecteur façonné sous la forme d'une coque en résine conductrice (42, 43) qui représente un article moulé en résine conductrice,
des terminaisons (55), où le câble tressé tubulaire est coupé et se termine, d'une partie terminale (54) du câble tressé tubulaire (52) sont repliées vers l'intérieur dans la direction axiale,
la partie terminale (54) du câble tressé tubulaire (52) est moulée en une seule pièce avec une partie insérée (61) de la coque en résine conductrice (42, 43), et
les terminaisons (55) sont laissées dans un état simplement coupé et restent simplement sectionnées de sorte à ce que les fils élémentaires (59) situés dans une partie interne (57) de la partie terminale (54), qui est formée en repliant les terminaisons (55) vers l'intérieur, soient formés à l'état non tressé.

2. Faisceau de câbles (30 à 33) selon la revendication 1, dans lequel les fibres non métalliques sont constituées de fibres de carbone ou de fibres de résine conductrice, les fibres de résine conductrice étant formées en mélangeant un matériau conducteur dans un matériau de résine.
